# EUROPEAN PATENT APPLICATION

(11) **EP 1 372 215 A2**
(43) Date of publication of application: **17.12.2003**
(21) Application number: 03291348.5
(22) Date of filing: 05.06.2003
(51) Int. Cl.: H01Q 1/38, H01Q 9/04, H01Q 23/00

(54) **Semiconductor module structure incorporating antenna**

(30) Priority: 13.06.2002 JP 2002173067
(71) Applicant: SHINKO ELECTRIC INDUSTRIES CO. LTD., Nagano-shi, Nagano 380-0921 (JP)
(72) Inventor: Mashino, Naohiro, c/o Shinko Electric Ind.Co.,Ltd., Nagano-shi, Nagano 380-0921 (JP)
(74) Representative: Quantin, Bruno Marie Henri

(57) **Abstract**

It is a task to reduce the length of an antenna by improving material of a module structure composing an antenna 3. A ferroelectric layer (2) is formed on the silicon board (1) and the antenna (3), composed of a conductor film, is formed on the ferroelectric layer (2). Through-holes (9) are formed on the silicon board (1). Electronic elements such as a capacitor (7), a SAW filter (8) and an inductance (6) are incorporated onto the silicon board (1) so as to compose a module structure.

## Description

### BACKGROUND OF THE INVENTION

### 1. Field of the Invention

The present invention relates to a structure of a semiconductor module incorporating an antenna and capable of functioning as an interposer. The present invention also relates to a method of manufacturing the same structure. More particularly, the present invention can be applied to manufacturing a multi-chip module in which an interposer is used.

### 2. Description of the Related Art

Conventionally, an antenna used for wireless communication is made of conductive material or a composition of a ceramic and a conductive material. However, depending on the frequency which is used for the wireless communication, the antenna structure may be restricted. For example, in the case where the wireless communication is conducted in the frequency band of 2.5 GHz using an antenna which is formed on a printed board made of usual glass epoxy, the dielectric constant of which is approximately 4.5, it is necessary to provide an antenna, the length of which is 18 mm. On the other hand, in the case where an antenna is formed on a board made of a ceramic, the dielectric constant of which is 10, it is necessary to provide an antenna, the length of which is about 13 mm.

Even when it is required to use material of a high dielectric constant, for a plane antenna, made of ceramic or a printed board, in general, the dielectric constant of the material used for the plane antenna or printed board seldom exceeds 100.

A prior art is disclosed in Japanese Unexamined Patent Publication No. 8-56113 in which a detector used for detecting millimeter waves is described. According to this prior art, a ground conductor film and a dielectric film are laminated on a semiconductor board made of silicon or gallium arsenide, and a plane antenna and a micro-strip path for supplying electric power to this plane antenna are formed on this dielectric film, and a second semiconductor board made of gallium arsenide, on which a signal detecting circuit or a signal generating circuit is provided, is mounted on the micro-strip path by means of flip chip bonding.

In this prior art, there is disclosed a structure in which, instead of forming the plane antenna on the dielectric film provided on the semiconductor board, a dielectric board is used, and a plane antenna formed on the board is supplied with electric power by a terminal, arranged on the back face, via a through-hole.

As described above, in the case where an antenna for conducting radio communication is formed on a printed board, conventionally, it is necessary to provide an antenna, the length of which is a predetermined value. Therefore, for example, it is impossible to incorporate the antenna into a silicon chip because a sufficiently large antenna forming region can not be ensured in the silicon chip.

### SUMMARY OF THE INVENTION

Therefore, it is an object of the present invention to provide a semiconductor module structure in which an antenna can be formed in a silicon chip when the length of the antenna is reduced by improving the material of the module structure on which the antenna is formed.

In order to accomplish the above object, according to the present invention, there is provided a semiconductor module structure comprising: a silicon board having a first and second surfaces, a ferroelectric layer is formed on at least a part of the first surface or and second surface of the silicon board; and an antenna composed of a conductor film formed on the ferroelectric layer. When the antenna is formed on the ferroelectric layer on the silicon board as described above, it becomes possible to reduce the length of the antenna to not more than 1.2 mm.

In this case, for example, zirconate titanate (PZT) is preferably used for the ferroelectrics. PZT is material made of a mixed ceramic containing lead zirconate titanate Pb (ZrxTi₁-x)O₃. The dielectric constant of PZT is approximately 1200. Accordingly, even when the dielectric constant of the silicon board itself is approximately 10, when the ferroelectric layer is formed on the silicon board, length of the antenna can be remarkably reduced to a value not more than 1.2 mm.

Electronic elements such as a capacitor, a SAW filter and an inductance are formed on the silicon board, on which an antenna is formed, and are incorporated into the module structure. Due to the above structure, not only the antenna but also electronic parts having various other functions can be mounted on one module structure. For example, such an electronic element has a coil-like configuration formed as a pattern on the silicon board.

A through-hole is formed on the silicon board, on which an antenna is formed, a conductor layer is formed on an inner wall face of the through-hole via an insulating layer, and the conductor layer is connected with conductor patterns provided on first and second surfaces of the silicon board. When the through-hole passing through both sides of the silicon board is formed on the silicon board as described above, the patterns provided on both sides of the board can be electrically connected to each other.

In this case, a ground layer is formed on a lower layer of the inner wall face of the through-hole via a first insulating layer, a signal layer is formed on an upper face of the ground layer via a second insulating layer, and the ground layer and the signal layer are respectively connected with the ground layer and the signal pattern provided on first and second surfaces of the silicon board.

### BRIEF DESCRIPTION OF THE DRAWINGS

Fig. 1 is a perspective view of a semiconductor module of the first embodiment of the present invention capable of being used as an interposer;
Fig. 2 is a sectional view showing a through-hole portion of the semiconductor module shown in Fig. 1;
Fig. 3 is a plan view of an inductance which is an example of the electronic parts capable of being formed on the semiconductor module of the present invention;
Fig. 4 is a sectional view showing a semiconductor module of the second embodiment of the present invention; and
Fig. 5 is a sectional view showing a semiconductor module of the third embodiment of the present invention.

### DETAILED DESCRIPTION OF THE PREFERRED EMBODIMENTS

Referring to the accompanying drawings, some of the embodiments of the present invention will now be explained, in detail, as follows.

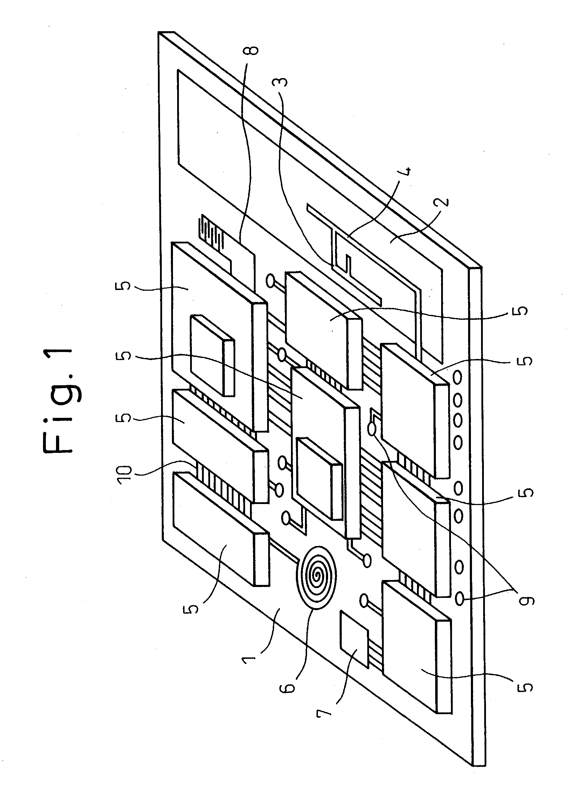

Fig. 1 is a perspective view of a semiconductor module of the first embodiment of the present invention capable of being used as an interposer. The semiconductor board 1 must be flat and rectangular. Further, the heat resistance of the semiconductor board 1 must be high. Furthermore, the property for mounting electronic parts such as an IC chip on the semiconductor board 1 must be high. For the above reasons, the present invention uses a silicon board. The dielectric constant of the silicon board 1 itself is approximately 10.

In a part of an area on the surface of the silicon board 1, that is, in the rectangular region longitudinally arranged along the right short side of the rectangular-shaped board 1, there is provided a ferroelectric layer 2. On this ferroelectric layer 2, the antenna 3, composed of a conductor film, is formed.

The ferroelectric layer 2 is made of, for example, PZT. PZT is a material made of a mixed ceramic containing lead zirconate titanate Pb (ZrxTi₁-x)O₃. The dielectric constant of PZT is approximately 1200.

The plan profile of the antenna 3 is formed into an F-shaped pattern. The size of the antenna is small, that is, the length L of the F-shaped antenna is not more than 1.2 mm, and the width W of the F-shaped antenna is not more than 1 mm. Electric power is supplied to this antenna 3 via the electric power supply pattern 4 formed on the board 1 and the ferroelectric layer 2.

In the region on the board 1 except for the region in which the ferroelectric layer 2 is formed, there are provided electronic circuit units or parts, such as a plurality of semiconductor chips 5, an inductance 6, a capacitor 7 and an SAW filter 8. These electronic parts are incorporated integrally with the silicon board 1 so that one multi-chip module (MCM) is composed. For example, the inductance 6, which is one of the electronic circuit parts, is conventionally mounted on the board as one of the parts. However, in this embodiment, the inductance 6 is integrally incorporated onto the surface of the silicon board 1.

A large number of through-holes 9, which penetrate both surfaces of the silicon board 1, are formed on the silicon board 1. Although not shown in the drawing, the silicon board 1 is provided with many through-holes 9 in the areas of the lower faces of the large number of chips 5. The through-holes 9 are connected with the circuit pattern 10. This circuit pattern 10 is connected with the antenna 3 formed on the silicon board 1 and is also connected with the electronic circuit pattern parts, such as the semiconductor silicon chip 5, inductance 6, capacitor 7 and SAW filter 8. Electric continuity between the circuit pattern provided on the surface of the board and the circuit pattern provided on the back face of the board is advantageously accomplished by the through-holes 9, since the wirings used for electric power supply, grounding and sending signals can be arranged on the inner walls of or in the through-holes 9.

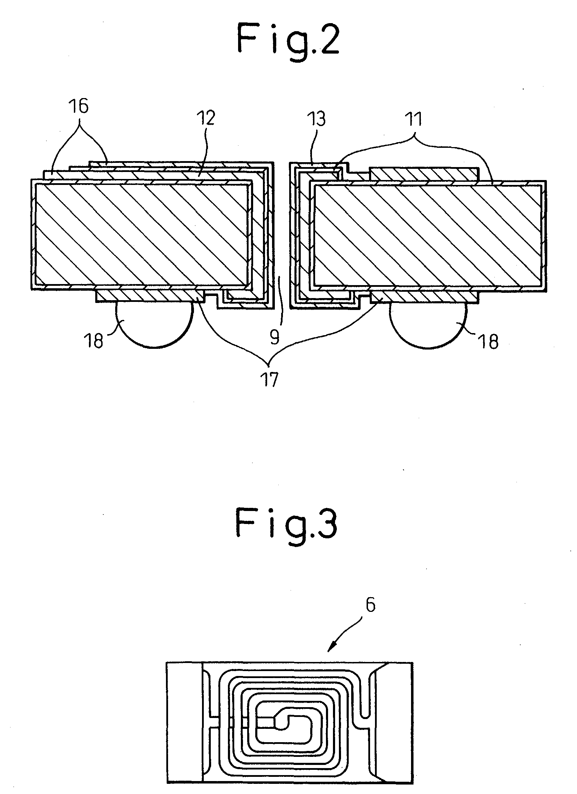

Fig. 2 is an enlarged cross-sectional view showing a through-hole portion of the semiconductor module shown in Fig. 1. On the silicon board 1, a large number of through-holes 9 are previously formed by means of laser beam machining or drilling so that the through-holes 9 can penetrate the board 1. On both sides of the silicon board 1 and on the wall faces of the through-holes 9, the insulating film 11 made of silicon oxide (SiO₂), which is formed, for example, by thermal oxidization of a silicon board, is formed. On this insulating film 11, the necessary conductor pads 12 and the conductor patterns 10 are formed. The conductor layers and conductor patterns can be formed on both sides of the silicon board 1 and on the inner walls of the through-holes 9 by conducting electrolytic plating of copper on a nickel-plated layer which has been formed by means of chemical vapor-deposition (CVD) or electroless plating.

In the case of the through-hole 9 shown in Fig. 2, on the insulating layer 11, the ground layer 12, which is a lower layer wiring, is formed. Further, on the ground layer 12, the insulating film 13 made of silicon oxide (SiO₂) is formed. Furthermore, the signal layer 14, which is a surface layer, is formed on the insulating film 13. The ground layer 12 and the signal layer 14, which are formed in the through-holes 9, are respectively connected with the ground pattern (lower layer wiring) 15 and the signal pattern 16 which are formed on both sides of the silicon board 1.

As terminals to be connected to the outside, for example, there are provided solder bumps 18 on the conductor pads 17. As shown in Fig. 2, the conductor pads 17 are connected with the signal patterns 16 provided on both sides of the silicon board 1. Further, the conductor pads 17 are connected with the signal patterns provided on the opposite side of the board 1 via the signal layers 14 of the through-holes. In this embodiment, shielding wires for wire bonding are not used but the conductors are connected with each other by the through-holes as described above. Accordingly, there is no possibility that the antenna is affected by noise.

Fig. 3 is a plan view of an inductance which is an example of an electronic part capable of being formed on the silicon board 1 of the semiconductor module shown in Fig. 1. This coil-shaped inductance 6 can be formed, for example, by conducting chemical etching on a conductive film of copper formed on the silicon board 1.

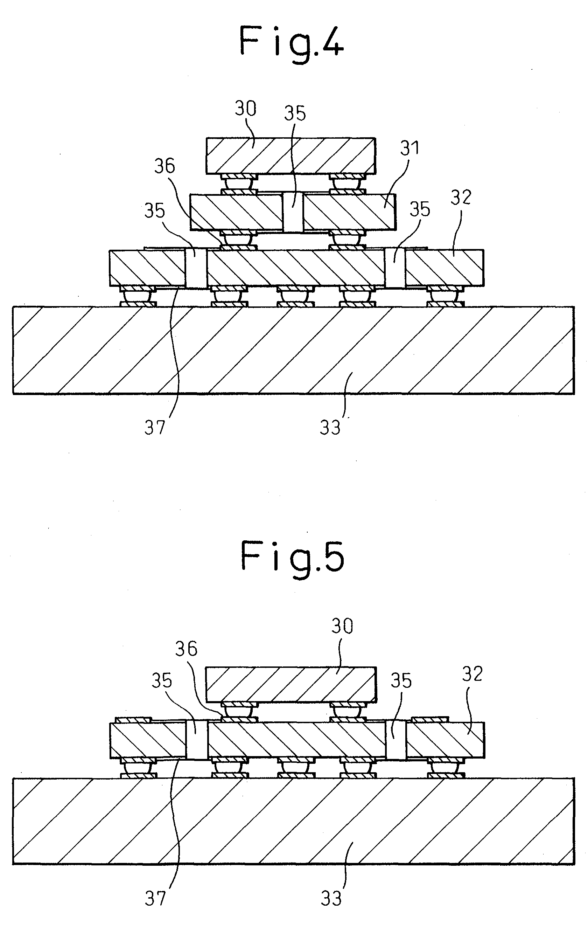

Fig. 4 is a view showing a semiconductor module of the second embodiment of the present invention. This semiconductor module is suitable when the board explained in Fig. 1 is used as an interposer. Fig. 4 shows a case in which a chip capacitor (decoupling capacitor) is mounted as an electronic part. A chip capacitor 30 is mounted on another chip capacitor or an interposer 31 by means of flip chip bonding. This chip capacitor or the interposer 31 has the aforementioned through-hole 35. Further, this silicon chip or the interposer 31 is mounted on still another chip capacitor or interposer 32 by means of flip chip bonding as described above. This chip capacitor or interposer 32 also has the through-hole 35 as described above. The chip capacitor or interposer 32 is mounted on the printed board or package 33 by means of flip chip bonding in the same manner as described above. In Fig. 4, reference numeral 36 is a conductor pad used for flip chip bonding, and reference numeral 37 is rewirings or secondary wirings.

Fig. 5 is a view showing a semiconductor module of the third embodiment of the present invention. In the same manner as that of the second embodiment shown in Fig. 4, the board is used as an interposer in this embodiment. The points this embodiment of Fig. 5 different from those of Fig. 4 are described as follows. The silicon chip or the interposer 31 arranged in the intermediate portion is omitted, and the chip capacitor (decoupling capacitor) 30, which is an electronic part, is mounted on another silicon chip 32 by means of flip chip bonding. This silicon chip 32 also has the same through-holes as those described above. The silicon chip 32 is mounted on the printed board or the package 33 by means of flip chip bonding in the same manner as that described before.

As explained above, according to the present invention, an antenna can be made compact and integrally incorporated into a silicon chip (silicon interposer). Therefore, a communication device can be made very small. Further, electronic parts such as a capacitor, a SAW filter and an inductance can be formed on the interposer simultaneously with the formation of the antenna. Therefore, the multi-chip module (MCM) can be manufactured at a reduced cost.

## Claims

1. A semiconductor module structure comprising:
a silicon board having first and second surfaces, a ferroelectric layer formed on at least a part of the first surface or the second surface of the silicon board; and
an antenna composed of a conductor film formed on the ferroelectric layer.

2. A semiconductor module structure, according to claim 1, wherein the ferroelectric layer is made of lead zirconate titanate (PZT).

3. A semiconductor module structure, according to claim 1, wherein electronic elements such as a capacitor, a SAW filter and an inductance are formed on the silicon board and incorporated into the module structure.

4. A semiconductor module structure, according to claim 3, wherein an electronic element has a coil-like configuration formed as a pattern on the silicon board.

5. A semiconductor module structure, according to claim 1, wherein a through-hole is formed in the silicon board, a conductor layer is formed on an inner wall face of the through-hole via an insulating layer, and the conductor layer is connected with conductor patterns provided on the first and second surfaces of the silicon board.

6. A semiconductor module structure according to claim 5, wherein a ground layer is formed on a lower layer of the inner wall face of the through-hole via a first insulating layer, a signal layer is formed on an upper face of the ground layer via a second insulating layer, and the ground layer and the signal layer are respectively connected with the ground layer and the signal pattern provided on the first and second surfaces of the silicon board.
